# EUROPEAN PATENT APPLICATION

(11) **EP 4 542 646 A1**
(43) Date of publication of application: **23.04.2025**
(21) Application number: 24190862.3
(22) Date of filing: 25.07.2024
(51) Int. Cl.: H01L 23/522, H01L 21/768, H01L 23/498, H01L 23/528

(54) **BRIDGE-FREE AND CMP-FRIENDLY INTERCONNECT STRUCTURE IN SEMICONDUCTOR DEVICE**

(30) Priority: 16.10.2023 US 202363544341 P; 27.03.2024 US 202418618469
(71) Applicant: SAMSUNG ELECTRONICS CO., LTD., Yeongtong-gu Suwon-si, Gyeonggi-do 16677 (KR)
(72) Inventor: OH, Joongsuk, San Jose, CA, 95134 (US); CHOI, Jaemyung, San Jose, CA, 95134 (US); SEO, Kang-ill, San Jose, CA, 95134 (US)
(74) Representative: Kuhnen & Wacker Patent- und Rechtsanwaltsbüro PartG mbB

(57) **Abstract**

Provided is a semiconductor device which includes: a transistor structure; a plurality of 1^{st} metal lines (M11, M12, M13, M14, M15) above the transistor structure; and a plurality of 1^{st} vias (dV, ATV) formed on selected 1^{st} metal lines, respectively, among the plurality of 1^{st} metal lines (M11, M12, M13, M14, M15); a 2^{nd} via (DV) formed on a 1^{st} via (ATV) among the plurality of 1^{st} vias (dV, ATV); and a 2^{nd} metal line (M22) on the 2^{nd} via (DV), wherein the 1^{st} metal lines (M11, M12, M13, M14, M15) are arranged in a 1^{st} direction (D1) and extended in a 2^{nd} direction (D2) which intersects the 1^{st} direction (D1), and the 2^{nd} metal line (M22) is extended in the 1^{st} direction (D1), and wherein the plurality of 1^{st} vias (dV, ATV) comprise at least one dummy via (dV) which is not connected to any metal line thereabove other than an underlying 1^{st} metal line among the selected 1^{st} metal lines.

## Description

### BACKGROUND

### 1. Field

Apparatuses and methods consistent with example embodiments of the disclosure relate to an interconnect structure including an active top via and dummy top vias.

### 2. Description of the Related Art

Performance of a semiconductor device may be affected by how an interconnect structure is formed in the semiconductor device. The interconnect structure may include back-end-of-line (BEOL) structures such as metal lines and vias which connect front-end-of-line (FEOL) structures to a voltage source or other circuit elements through middle-of-line (MOL) structures. The FEOL structures may include a channel structure, source/drain regions, a gate structures of a transistor, and the MOL structures may include contact plugs respectively formed on the source/drain regions and the gate structures.

As semiconductor devices are developed to have a high device density and performance, design and formation of an interconnect structure including metal lines and vias becomes more difficult and complicated while improved resistance and capacitance (RC) characteristics are required for the semiconductor device.

Information disclosed in this Background section has already been known to the inventors before achieving the embodiments of the present application or is technical information acquired in the process of achieving the embodiments described herein. Therefore, it may contain information that does not form prior art that is already known to the public.

### SUMMARY

The disclosure provides example embodiments of an interconnect structure for a semiconductor device or an integrated circuit. The invention is set out in the appended claims.

According to one or more embodiments, there is provided a semiconductor device which may include: a transistor structure; a plurality of 1^{st} metal lines above the transistor structure; and a plurality of 1^{st} vias formed on selected 1^{st} metal lines, respectively, among the plurality of 1^{st} metal lines; a 2^{nd} via formed on a 1^{st} via among the plurality of 1^{st} vias; and a 2^{nd} metal line on the 2^{nd} via, wherein the 1^{st} metal lines are arranged in a 1^{st} direction and extended in a 2^{nd} direction which intersects the 1^{st} direction, and the 2^{nd} metal line is extended in the 1^{st} direction, and wherein the plurality of 1^{st} vias comprise at least one dummy via which is not connected to any metal line thereabove other than an underlying 1^{st} metal line among the selected 1^{st} metal lines.

According to one or more embodiments, each of the selected 1^{st} metal lines and each of the plurality of 1^{st} vias thereon is formed of ruthenium (Ru), and does not have a connection surface, boundary or interface therebetween.

According to one or more embodiments, there is provided a semiconductor device which may include: a transistor structure; a 1^{st} metal line on the transistor structure; a 1^{st} via on the 1^{st} metal line; a 1^{st} isolation layer surrounding the 1^{st} metal line and the 1^{st} via; a 2^{nd} via on the 1^{st} via; a 2^{nd} metal line on the 2^{nd} via; and a 2^{nd} isolation layer surrounding the 2^{nd} via, wherein the 1^{st} metal line and the 1^{st} via does not have a connection surface, boundary or interface therebetween, wherein a diffusion barrier layer is formed between the 2^{nd} via and the 2^{nd} isolation layer, and wherein a diffusion barrier layer is not formed between the 1^{st} via and the 1^{st} isolation layer.

According to one or more embodiments, there is provided a semiconductor device which may include: a transistor structure; and a plurality of 1^{st} metal lines above the transistor structure, the plurality of 1^{st} metal lines being arranged in a 1^{st} direction and extended in a 2^{nd} direction which intersects the 1^{st} direction; a plurality of 1^{st} vias on selected 1^{st} metal lines among the plurality of 1^{st} metal lines; and a plurality of 2^{nd} metal lines above the plurality of 1^{st} vias, the plurality of 2^{nd} metal lines being arranged in the 2^{nd} direction and extended in the 1^{st} direction, wherein the plurality of 1^{st} vias include: a 1^{st} via connected to a 2^{nd} metal line among the 2^{nd} metal lines; and a plurality of dummy vias not connected to any of the 2^{nd} metal lines, and wherein the plurality of 1^{st} vias are arranged in the 1^{st} direction at a 1^{st} pitch and arranged in the 2^{nd} direction at a 2^{nd} pitch.

According to one or more embodiments, there is provided a method of manufacturing a semiconductor device. The method may include: forming a front-end-of-line (FEOL) structure and an interconnect structure thereabove, wherein the forming the interconnect structure includes: forming a plurality of 1^{st} metal lines; patterning selected 1^{st} metal lines among the plurality of 1^{st} metal lines to form a plurality of 1^{st} vias from the selected 1^{st} metal lines; forming a 1^{st} isolation layer to enclose the 1^{st} metal lines and the plurality of 1^{st} vias; planarizing or polishing the 1^{st} isolation layer to expose the plurality of 1^{st} vias; and forming a plurality of 2^{nd} metal lines and a 2^{nd} via connected to one of the plurality of 2^{nd} metal lines such that the 2^{nd} via is formed on a 1^{st} via among the plurality of 1^{st} vias, wherein the 1^{st} vias other than the 1^{st} via among the plurality of 1^{st} vias are not connected to any of the 2^{nd} metal lines.

### BRIEF DESCRIPTION OF DRAWINGS

Example embodiments of the disclosure will be more clearly understood from the following detailed description taken in conjunction with the accompanying drawings as follows.
FIGS. 1A-1C illustrate an interconnect structure including a plurality of metal lines and a via formed through a damascene process for a semiconductor device, according to one or more embodiments.
FIGS. 2A-2C illustrate a semiconductor device including an interconnect structure which includes a plurality of metal lines and a via formed through a top via process, according to one or more embodiments.
FIGS. 3A and 3B illustrate interconnect structures in which top vias are improperly formed, according to one or more embodiments.
FIGS. 4A and 4B illustrate interconnect structures in which overlying metal lines that are improperly formed because of CMP dishing, according to one or more embodiments.
FIGS. 5A-5C illustrate a semiconductor device including a hybrid interconnect structure which includes a plurality of metal lines and vias formed through both a top via process and a damascene process, according to one or more embodiments.
FIGS. 6A and 6B are plan views of top via formation in the interconnect structure shown in FIGS. 2A-2C and the interconnect structure shown in FIGS. 5A-5C, respectively, according to one or more embodiments.
FIGS. 7A-7C illustrate a semiconductor device including a hybrid interconnect structure which includes a plurality of metal lines and vias formed through both a top via process and a damascene process, according to one or more other embodiments.
FIG. 8 illustrates a flowchart for a method of manufacturing a semiconductor device including a hybrid interconnect structure through both a top via process and a damascene process, according to one or more embodiments.
FIG. 9 is a schematic block diagram illustrating an electronic device including at least one of the interconnect structures shown in FIGS. 5A-5C and 7A-7C, according to one or more embodiments.

### DETAILED DESCRIPTION OF EMBODIMENTS

The embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof. For example, channel layers, sacrificial layers, and isolation layers described herein may take a different type or form as long as the disclosure can be applied thereto.

It will be understood that when an element, component, layer, pattern, structure, region, or so on (hereinafter collectively "element") of a semiconductor device is referred to as being "over," "above," "on," "below," "under," "beneath," "connected to" or "coupled to" another element of the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions herebelow, the "left" element and the "right" element may also be referred to as a "1^{st}" element or a "2^{nd}" element, respectively, as long as their structural relationship is clearly understood in the context of the descriptions. Similarly, the terms a "lower" element and an "upper" element may be respectively referred to as a "1^{st}" element and a "2^{nd}" element with necessary descriptions to distinguish the two elements.

It will be understood that, although the terms "1^{st}," "2^{nd}," "3^{rd}," "4^{th}," "5^{th}," "6^{th}," etc. may be used herein to describe various elements, these elements should not be limited by these terms. These terms are only used to distinguish one element from another element. Thus, a 1^{st} element discussed below could be termed a 2^{nd} element without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" or "equal" is used to compare a dimension of two or more elements, the term may cover a "substantially same" or "substantially equal" dimension.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements of a semiconductor device may or may not be described in detail herein or shown in the drawings. For example, MOL or FEOL structures may not be shown or described in detail when these structures are not relevant to the concept of the disclosure.

Herebelow, various embodiments of the disclosure are described in reference to the accompanying drawings.

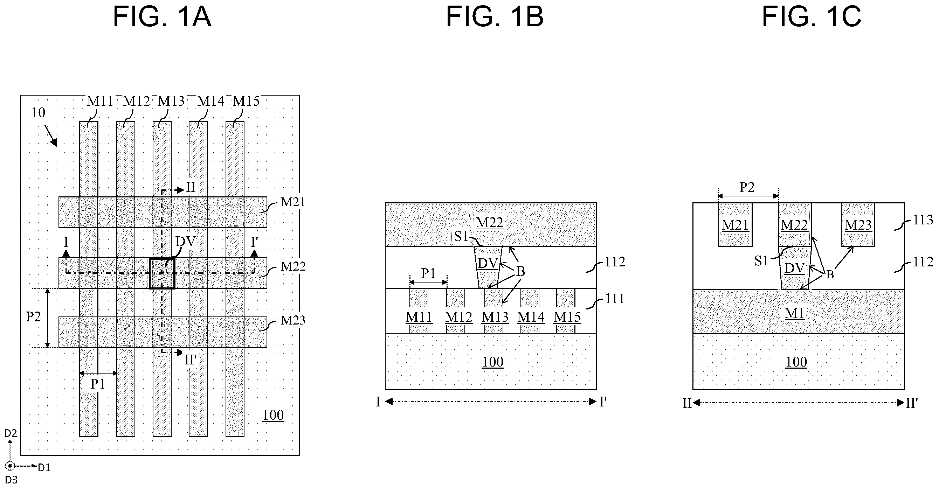

FIGS. 1A-1C illustrate an interconnect structure including a plurality of metal lines and a via formed through a damascene process for a semiconductor device, according to one or more embodiments. FIG. 1A is a plan view of the interconnect structure, FIG. 1B is a side cross-sectional view of the interconnect structure taken along a line I-I' shown in FIG. 1A, and FIG. 1C is a side cross-sectional view of the interconnect structure taken along a line II-II' shown in FIG. 1A.

Referring to FIGS. 1A-1C, an interconnect structure 10 may be formed on a base layer 100 which may be another interconnect structure in a back-end-of-line (BEOL) layer where the interconnect structure 10 is included, a middle-of-line (MOL), or a front-end-of-line (FEOL) layer.

The interconnect structure 10 may include a plurality of M1 metal lines M11-M15 (e.g., above or on a transistor structure not shown in the figures), a via DV, and a plurality of M2 metal lines M21-M23 surrounded by inter-metal dielectric (IMD) layers 111, 112 and 113, respectively. The M1 metal lines may be arranged in a D1 direction and extended in a D2 direction, and the M2 metal lines formed above the M1 metal lines with the via DV therebetween may be arranged in the D2 direction and extended in the D1 direction. The D1 and D2 directions are each a horizontal direction and intersect each other. The D3 direction is a vertical direction intersecting the D1 and D2 directions. The via DV may connect the M1 metal line M13 to the M2 metal line M22. It is noted here that the M1 metal lines do not necessarily indicate that these metal lines are formed in the lowest layer of the BEOL layer, and there may be one or more other metal lines and vias below the M1 metal lines on the MOL or FEOL layer 100 to form a semiconductor device.

The interconnect structure 10 may be formed through a damascene process in which IMD layers 111, 112 and 113 are respectively patterned through photolithography/masking/etching operations to form trenches and via holes where a diffusion barrier layer B is layered, and a metal or metal compounding such as copper (Cu), aluminum (Al), tungsten (W), etc. are filled in the trench and via holes with the diffusion barrier layer B thereon to form the M1 and M2 metal lines and the via DV The diffusion barrier layer B may also be formed to secure adhesion between the M1 metal line M13, the via DV and the M2 metal line M22 which are connected to each other for current flow. The IMD layers 111 and 112 may be formed of a low-k material such as silicon oxide (SiO₂, etc.), not being limited thereto, which isolates the M1 and M2 metal lines and via DV from each other or another circuit element. The diffusion barrier layer B may be formed of a metal such as titanium (Ti), titanium nitride (TiN), tantalum (Ta), tantalum nitride (TaN), etc., not being limited thereto, which prevents atoms of the metal (e.g., Cu) filled in the trenches and holes from migrating into the IMD layers 111 and 112 to deteriorate isolation performance of the IMD layers 111 and 112. Further, the diffusion barrier layer B may facilitate adhesion of the metal to the IMD layers 111 and 112.

The via DV and the M2 metal lines may be formed in the IMD layers 112 and 113 through respective single damascene processes, in which case a connection surface, interface, or boundary S1 may exist between the M2 metal line M22 and the via DV However, when the M2 metal line M22 and the via DV are formed though a dual damascene process, the connection surface, interface, or boundary S1 may not exist therebetween because the via DV may be a part of the M2 metal line M22, and the IMD layers 112 and 113 may be a single isolation layer.

In the meantime, the interconnect structure 10 may be formed such that the M1 metal lines have a predetermined fine pitch P1 which is smaller than a predetermined pitch P2 of the M2 metal lines formed above the M1 metal lines. Thus, when the via DV is formed to be connected to the metal line M13 through a single or dual damascene operation, there is a risk of misalignment between the via DV and the M1 metal line M12 or M14 adjacent to the M1 metal line M13 because of the fine pitch P1 regardless of the IMD layers 111 and 112, as shown in FIG. 1B. Thus, a short circuit or bridging between the via DV and the M1 metal line M12 or M14 may occur.

Therefore, at least to address the short-circuit or bridging risk that may occur in the interconnect structure 10 of the above embodiment, the following embodiments of an interconnect structure are provided.

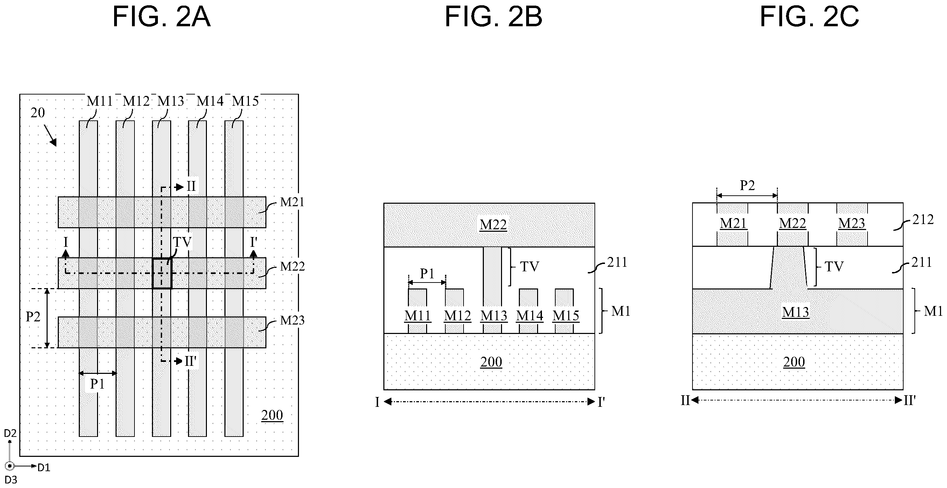

FIGS. 2A-2C illustrate a semiconductor device including an interconnect structure which includes a plurality of metal lines and a via formed through a top via process, according to one or more embodiments. FIG. 2A is a plan view of the interconnect structure, FIG. 2B is a side cross-sectional view of the interconnect structure taken along a line I-I' shown in FIG. 2A, and FIG. 2C is a side cross-sectional view of the interconnect structure taken along a line II-II' shown in FIG. 2A.

Referring to FIGS. 2A-2C, an interconnect structure 20 may have the same metal line and via arrangement including the fine metal pitches P1 and P2 as that of the interconnect structure 10 shown in FIGS. 1A-1C. Further, the interconnect structure 20 may also be formed on a base layer 200 which may be another interconnect structure in a BEOL layer including the interconnect structure 20 or an MOL or FEOL layer 200, similar to the interconnect structure 10. Thus, duplicate descriptions thereof may be omitted herein, and instead, different aspects of the interconnect structure 20 may be described herebelow.

Like the interconnect structure 10, the interconnect structure 20 may also include a plurality of M1 metal lines M11-M15 (e.g., above or on a transistor structure not shown in the figures), a via TV and a plurality of M2 metal lines M21-M23 surrounded by IMD layers 211 and 212, respectively. However, while the via DV in the interconnect structure 10 may be formed through a damascene process to connect an M1 metal line M13 with an M2 metal line M22, the corresponding via TV in the interconnect structure 20 may be formed from the M1 metal line M13 through a top via process. Here, the via TV formed on the M1 metal line M13 is a part of the M1 metal line M13 itself. Herein, a via, such as the via TV of the interconnect structure 20, formed through a top via process is referred to as a top via, while a via, such as the via DV of the interconnect structure 10, formed through a damascene process is referred to as a damascene via.

In addition to the top via TV, at least the M1 metal lines of the interconnect structure 20 may be formed of a metal such as ruthenium (Ru) that provides material and chemical characteristics (grain size, chemical resistance, thermal stability, etc.) required for implementing metal lines of a fine pitch (e.g., the pitch P1 shown in FIGS. 2A-2C), according to an embodiment. Molybdenum (Mo) or cobalt (Co) may also be considered as an alternative to Ru for the M1 metal lines, according to another embodiment. The M2 metal lines may also be formed of the same metal forming the M1 metal lines, or different metal lines such as Cu, Al, W, etc.

A top via is introduced to reduce contact resistance and capacitance existing between a metal line and a via formed thereon through a damascene process, which adversely affects at least connection performance of a semiconductor device including the metal line and the via. To form the top via, a metal structure (e.g., Ru) may be first patterned, and recessed except a masked region for via formation through, for example, photolithography, making and etching operations. As a result, the recessed region of the metal structure forms an underlying metal line and the masked region forms a via (i.e., top via). Thus, the top via and the underlying metal line may be a single continuum structure that does not have a boundary, a connection surface or an interface therebetween, unlike a damascene via and a damascene metal line formed through respective single damascene processes. After the metal line and the top via are patterned, an IMD layer may be formed to enclose the metal line and the top via. Thus, a risk of metal atom diffusion into the IMD layer that occurs in a damascene process may not occur in the top via process, so that a diffusion barrier layer such as the diffusion barrier layer B formed in the interconnect structure 10 of FIGS. 1A-1C does not need to be formed between the IMD layer and the metal line with the top via thereon. Accordingly, the M1 metal lines and the top via TV of the interconnect structure 20 may be formed in this manner, and no diffusion barrier layer may be formed between the IMD layer 211 and each of the M2 metal lines and the top via TV

While the interconnect structure 10 of FIGS. 1A-1C is formed such that the damascene via DV is aligned with the M1 metal line M13 among the M1 metal lines having the fine pitch P1 to connect the M1 metal line M13 with the M2 metal line M22, the interconnect structure 20 is formed such that the top via TV formed on the M1 metal line M13 is aligned with the M2 metal line M22 among the M2 metal lines having the pitch P2 which is greater than the fine pitch P1. Thus, a risk of short-circuit or bridging between the top via TV and an M2 metal line M21 or M22 which is not to be connected to the top via TV may be reduced. For example, the top via TV connected to the M2 metal line M22 may have a greater margin with respect to the adjacent M2 metal line M21 and M23 due to the pitch P2, which is greater than the fine pitch P1, as shown in FIGS. 2A-2C, while the damascene via DV connected to the M1 metal line M13 has a shorter margin with respect to the adjacent M1 metal lines M12 and M14 as shown in FIG. 1B. Thus, the interconnect structure 20 may enhance at least connection performance of a semiconductor device including the interconnect structure 20 compared to a semiconductor device including the interconnect structure 10 of FIGS. 1A-1C.

However, the risk of short-circuit or bridging between the top via TV and the M2 metal lines M21 or M23 may not be clearly removed because there still is possibility of misalignment between the M2 metal line M22 and the top via TV when the M2 metal lines are formed through photolithography/masking/etching/deposition operations. Further, formation of the top via TV for the interconnect structure 20 presents various challenges such as a via loss and chemical-mechanical polishing (CMP) dishing because of difficulties in a fine CMP operation on the IMD layer 211 enclosing the high-density M1 metal lines.

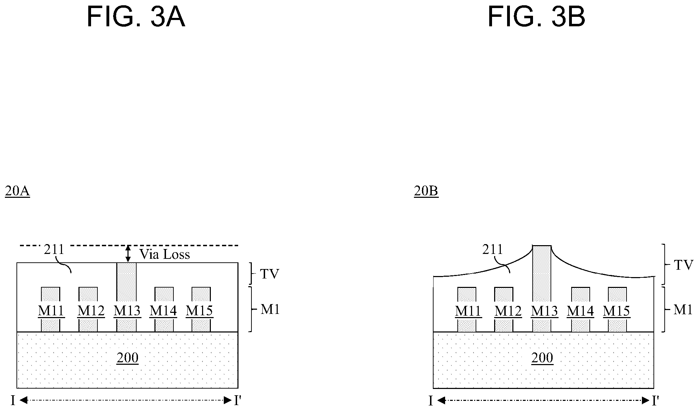

FIGS. 3A and 3B illustrate interconnect structures in which top vias are improperly formed, according to one or more embodiments.

Interconnect structures 20A and 20B respectively shown in FIGS. 3A and 3B are variants of the interconnect structure 20 shown in FIGS. 2A-2C after the M1 metal lines including the top via TV are formed and before the M2 metal lines are formed thereabove. Thus, the same reference numbers used in the above description of the interconnect structure 20 are used in describing the interconnect structures 20A and 20B herebelow.

In a BEOL process of forming the interconnect structure 20 shown in FIGS. 2A-2C, after the underlying M1 metal lines M11-M15 including the top via TV are formed, the IMD layer 211 may be formed to enclose the M1 metal lines including the top via TV, and then, a CMP operation may be performed to expose the top via TV for connection with the overlying M2 metal line M22. However, as the number of top vias TV formed on the underlying M1 metal lines in the interconnect structure 20 is too small, for example, only one as shown in FIGS. 2A-2C, detecting the top via TV for a subsequent CMP operation may be very difficult. Thus, over-CMP may occur to the top via TV on the M1 metal line M13, resulting in an irregular via loss phenomenon as shown in FIG. 3A. Otherwise, even when the top via TV is early detected and the CMP operation stops timely to expose the top via TV, CMP dishing may occur to the IMD layer 211, as shown in FIG. 3B, because of difference in rigidity and etch selectivity between the low-k dielectric material (e.g., SiO₂) of the IMD layer 211 and the metal (e.g., Ru) of the top via TV When the CMP dishing occurs, the IMD layer 211 may be over-etched outwardly from the top via TV

As a result of the irregular via loss, heights of a plurality of top vias, if any, including the top via TV may vary, and thus, a subsequent operation of forming the overlying M2 metal lines on the top vias may become unstable. As a result of the CMP dishing, the overlying metal line heights may vary, or an unCMP phenomenon may follow.

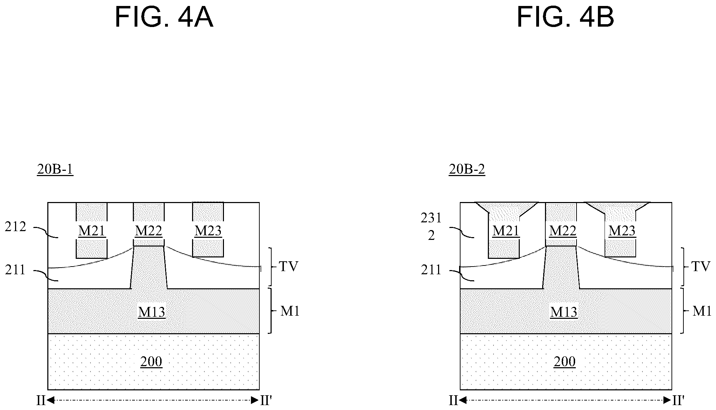

FIGS. 4A and 4B illustrate interconnect structures in which overlying metal lines are improperly formed because of CMP dishing, according to one or more embodiments.

Interconnect structures 20B-1 and 20B-2 respectively shown in FIGS. 4A and 4B are variants of the interconnect structure 20 shown in FIGS. 2A-2B after the M2 metal lines are formed on the interconnect structure 20B of FIG. 3B. Thus, the same reference numbers used in the description of the interconnect structures 20 and 20B are used in describing the interconnect structures 20B-1 and 20B-2 herebelow.

Referring to FIG. 4A, the overlying M2 metal lines M21, M22 and M23 surrounded by the IMD layer 212 may have different heights when CMP dishing occurs, by which at least estimation of metal resistance may become very difficult in manufacturing a semiconductor device including the interconnect structure 20B-1. Referring to FIG. 4B, an unCMP phenomenon occurring from the CMP dishing may result in a possible short-circuit risk between the overlying M2 metal lines M21, M22 and M23 surrounded by an IMD layer 312. Thus, when a semiconductor device is manufactured to include the interconnect structures 20B-1 or 20B-2, connection performance of the semiconductor device may be deteriorated.

Embodiments presented herebelow address the above-described over-CMP and CMP dishing as well as the risk of short-circuit or bridging between metal lines and vias.

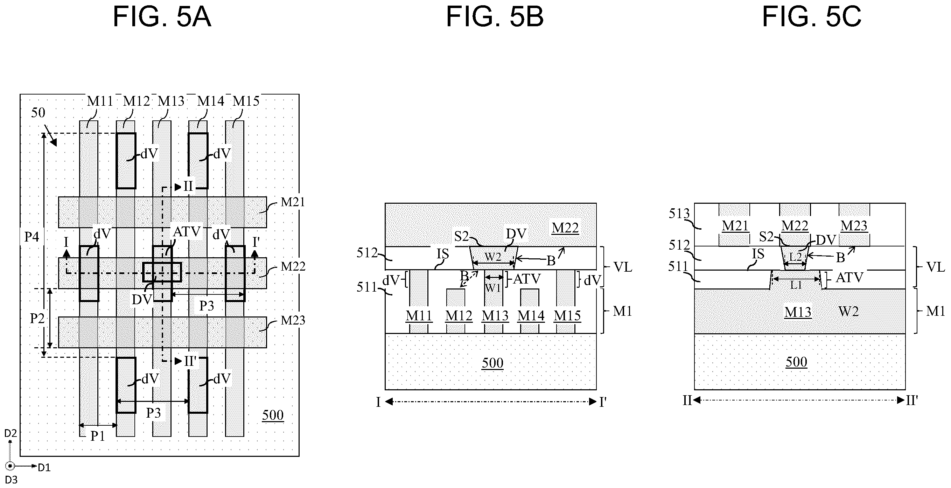

FIGS. 5A-5C illustrate a semiconductor device including a hybrid interconnect structure which includes a plurality of metal lines and vias formed through both a top via process and a damascene process, according to one or more embodiments. FIG. 5A is a plan view of the interconnect structure, FIG. 5B is a side cross-sectional view of the interconnect structure taken along a line I-I' shown in FIG. 5A, and FIG. 5C is a side cross-sectional view of the interconnect structure taken along a line II-II' shown in FIG. 5A.

Referring to FIGS. 5A-5C, an interconnect structure 50 may have the same metal line arrangement including the metal pitches P1 and P2 as that of the interconnect structure 20 shown in FIGS. 2A-2C. Further, the interconnect structure 50 may also be formed on a base layer 500 which may be another interconnect structure in a BEOL layer including the interconnect structure 50 or an MOL or FEOL layer. Thus, duplicate descriptions thereof may be omitted herein, and instead, different aspects of the interconnect structure 50 may be described herebelow.

Like the interconnect structure 20, the interconnect structure 50 may also include a plurality of M1 metal lines M11-M15 (e.g., above or on a transistor structure not shown in the figures) and M2 metal lines M21-M23. Further, the interconnect structure 50 may include a top via ATV formed from the M1 metal line M13 to be connected to the M2 metal line M22 as in the interconnect structure 20.

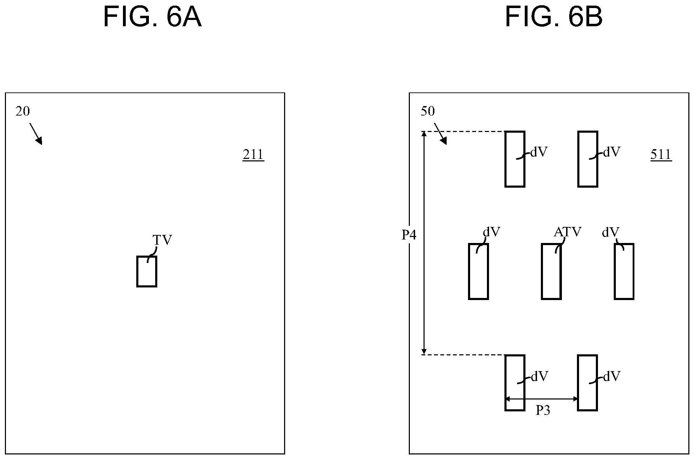

However, the interconnect structure 50 may include additional top vias dV formed on the M1 metal lines M11-M15. These additional top vias dV are dummy top vias which are not to be connected to any M2 metal lines thereabove including the M2 metal lines M21-M23, while the top via ATV is an active top via connected to the M2 metal line M22. Instead of being connected to any of the M2 metal lines, the dummy top vias dV may be formed in the interconnect structure 20 to facilitate a CMP operation to expose the top vias ATV and dV For example, the dummy top vias dV may enable easy and fast detection of the active top via TV along with the dummy top vias dV by increasing a density of top vias in a unit area (e.g., an area of the interconnect structure 50). The dummy top vias dV may also enable the CMP operation to have better planarity and uniformity as shown in FIGS. 6A and 6B. For these purposes, the top vias including the active top via TV and the dummy top vias dV may be formed in the interconnect structure 50 in predetermined pitches P3 and P4 in the D1 and D2 directions, respectively. Further, the dummy top vias dV may be formed at a same level to facilitate the CMP operation. For example, top surfaces of the dummy top vias dV may be at a same level in the D2 direction.

FIGS. 6A and 6B are plan views of top via formation in the interconnect structure 20 of FIGS. 2A-2C and the interconnect structure 50 of FIGS. 5A-5C, respectively, according to one or more embodiments.

In a BEOL process to obtain the interconnect structure 20 of FIGS. 2A-2C, the M1 metal lines M11-M15 may be formed first and the top via TV may be formed on the M1 metal line M13, followed by formation of the IMD layer 211 to enclose the M1 metal lines and the top via TV to isolate the M1 metal lines from each other or another circuit element. Subsequently, the IMD layer 211 may be planarized by a CMP operation to expose the top via TV (e.g., a top surface thereof) for a next operation of forming the M2 metal line M22 on the top via TV

Referring to FIG. 6A, the interconnect structure 20 may have a very low density of top via because the top via TV is the only top via included in the interconnect structure 20, and thus, detection of the top via TV during the CMP operation may be very difficult, which may result in a via loss or CMP dishing as described with reference to FIGS. 3A and 3B.

In contrast, FIG. 6B shows that the interconnect structure 50 may have a greater density of top vias due to the plurality of dummy vias dV along with the active top via ATV included in the interconnect structure 50. Further, these top vias may be arranged in the predetermined pitches P3 and P4. Thus, detection of the active top via ATV may be easy and fast during the CMP operation so that the CMP operation may timely stop and enable formation of the planar and uniform IMD layer 511, thereby preventing a via loss and CMP dishing.

Referring back to FIGS. 5A-5C, the interconnect structure 50 may also include a damascene via DV formed on the active top via ATV and below the M2 metal line M22 to connect the active top via ATV to the M2 metal line M22. The damascene via DV and the M2 metal lines including the M2 metal line M22 may be formed in IMD layers 512 and 513 through respective single damascene processes, and thus, a diffusion barrier layer B may be layered between the IMD layer 512 and the damascene via DV and between the IMD layer 513 and each of the M2 metal lines. Further, a connection surface, boundary or interface S2 may exist between the M2 metal line M22 and the damascene via DV, although this connection surface, boundary or interface S2 may not exist when the M2 metal line M22 and the damascene via DV are formed through a dual damascene process. Further, in the interconnect structure 50, the active top via ATV along with the dummy top vias dV may be formed to have a uniform smaller height than the top via TV of the interconnect structure 20 shown in FIGS. 2A-2C. Thus, in a via layer VL of the interconnect structure 50, both the active top via ATV and the damascene via DV may be formed.

The foregoing structural configuration of the interconnect structure 50 is provided to prevent unwanted connection of the dummy top vias dV to the M2 metal lines M21-M23. For example, when the damascene via DV is not formed and all of the dummy top vias dV and the active top via ATV are formed to have the same height as the top via TV in the interconnect structure 20 shown in FIGS. 2A-2C, the dummy top vias dV may also be connected to the overlying M2 metal line M22. Thus, while the active top via ATV is formed to have a smaller height, the additional damascene via DV may be formed in the IMD layer 512 to connect the M22 metal line to the active top via ATV through a damascene process.

Moreover, when both the active top via ATV and the damascene via DV are formed in the via layer VL of the interconnect structure 50 as shown FIGS. 5A-5C while only one of the damascene via DV or the top via is formed in a corresponding via layer of the interconnect structure 10 or 20 as shown in FIGS. 1A-1C and 2A-2C, an independent plane or surface IS may be formed between the underlying M1 metal lines and the overlying M2 metal lines. This independent plane or surface IS may be the same as a boundary between the IMD layers 511 and 512, and provide an isolation space for metal lines and vias. Further, when the dummy top vias dV are formed to have the predetermined pitches P3 and P4 in the D1 and D2 directions, respectively, the dummy top vias dV may be formed such that a dummy top via dV is not formed right next to the active top via ATV For example, no dummy top via dV is formed on or from the M1 metal lines M12 and M14 right next to the M2 metal line M13 on which the active top via ATV is formed.

Thus, even if the damascene via DV is formed on the active top via ATV on the M1 metal line M13, enough space may be provided between the damascene via DV and the M1 metal lines M12 and M14. Thus, a risk of short-circuit or bridging may not exist or may be small between the damascene via DV and each of the M1 metal lines M12 and M14. Further, as shown in FIG. 5C, due to a smaller height of the active top via ATV compared to the top via TV of interconnect structure 20, a risk of short-circuit or bridging between the active top via ATV and each of the metal lines M21 and M23 may be more clearly removed or reduced.

Moreover, when no dummy top vias dV are formed right next to the active top via ATV as shown in FIG. 5B, the damascene via DV may be formed to have a width W2 which is greater than a width W1 of each of the active top via ATV and the M1 metal lines in the D1 direction, and thus, a damascene process to form a space where the damascene via DV is formed may be performed more easily with a reduced risk of misalignment with the underlying active top via ATV in the D1 direction. Further, the active top via ATV as well as the dummy top vias dV may each be formed to have a length L1 which is greater than a length L2 of the damascene via DV in the D2 direction. Thus, in the CMP operation, the detection of the active top via ATV and the dummy top vias dV may be easy and fast, and also, a risk of misalignment with the overlying damascene via DV in the D2 direction may be reduced.

However, the size of the active top via ATV and the dummy top vias dV is not limited to the above embodiments. The active top via ATV and the dummy top vias dV may have different forms or shapes to have a different size, according to one or more embodiments.

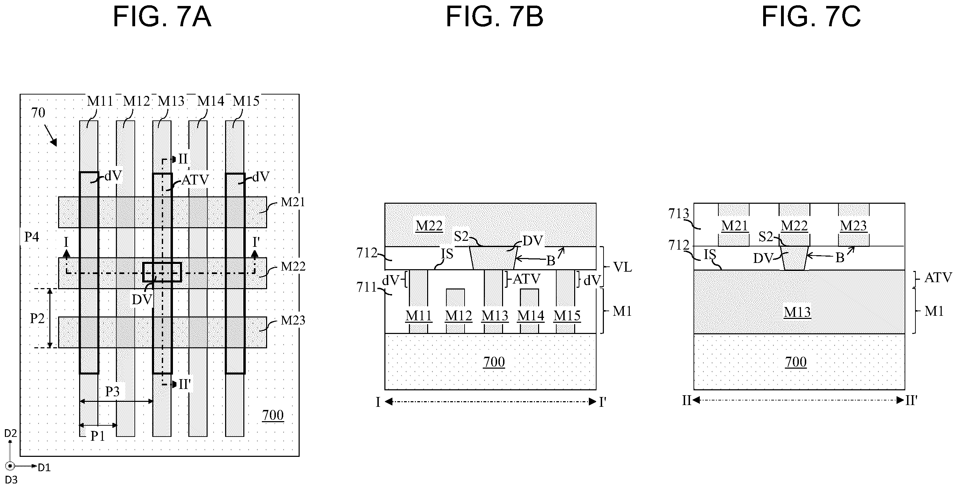

FIGS. 7A-7C illustrate a semiconductor device including a hybrid interconnect structure which includes a plurality of metal lines and vias formed through both a top via process and a damascene process, according to one or more other embodiments. FIG. 7A is a plan view of the interconnect structure including, FIG. 7 is a side cross-sectional view of the interconnect structure taken along a line I-I' shown in FIG. 7A, and FIG. 7C is a side cross-sectional view of the interconnect structure taken along a line II-II' shown in FIG. 7A.

Referring to FIGS. 7A-7C, an interconnect structure 70 may have the same metal line arrangement including the metal pitches P1 and P2 as that of the interconnect structure 50 shown in FIGS. 5A-5C. Further, the interconnect structure 70 may also be formed on a base layer 700 which may be another interconnect structure in a BEOL layer including the interconnect structure 70 or an MOL or FEOL layer. Thus, duplicate descriptions thereof may be omitted herein, and instead, different aspects of the interconnect structure 70 may be described herebelow.

Similar to the interconnect structure 50 of FIGS. 5A-5C, the interconnect structure 70 may also include a plurality of M1 metal lines M11-M15 (e.g., above or on a transistor structure not shown in the figures) and an active top via ATV along with dummy top vias dV formed though a top via process and surrounded by an IMD layer 711. The interconnect structure 70 may also include a plurality of M2 metal lines M21-M23 and a damascene via DV surrounded by IMD layers 713 and 712, respectively, and formed though respective single damascene processes.

However, each of the active top via ATV and the dummy top vias dV in the interconnect structure 70 may be of a line or bar type which is extended long in the D2 direction across the M2 metal lines M21-M23. This structural configuration of the top vias ATV and dV may be enabled due to a smaller height of the active top via ATV and the formation of the damascene via DV between the active top via ATV and the M2 metal line M22.

As shown in FIG. 7C, the interconnect structure 70 may be able to more clearly avoid a possible misalignment of the damascene via DV with the underlying active top via ATV which is extended long in the D2 direction, while an enough space can be provided between the active top via ATV and the overlying M2 metal lines M21 and M23. Thus, the interconnect structure 70 may also avoid a risk of short-circuit or bridging between the active top via ATV and the overlying M2 metal line M21 or M23. Further, as shown FIG. 7B, an enough space can be provided between the damascene via DV and the M1 metal lines M12 and M14 as in the interconnect structure 50, so that a risk of short-circuit or bridging therebetween may also be avoided.

Moreover, the formation of the top vias ATV and dV with a predetermined pitch P3 in the D1 direction may also enable easy and fast detection of these top vias during a CMP operation as well as and planar and uniform formation of the IMD layer 711 surrounding the M1 metal lines and the top vias ATV and dv.

Herebelow, a method of forming a hybrid interconnect structure such as the interconnect structure 50 is provided.

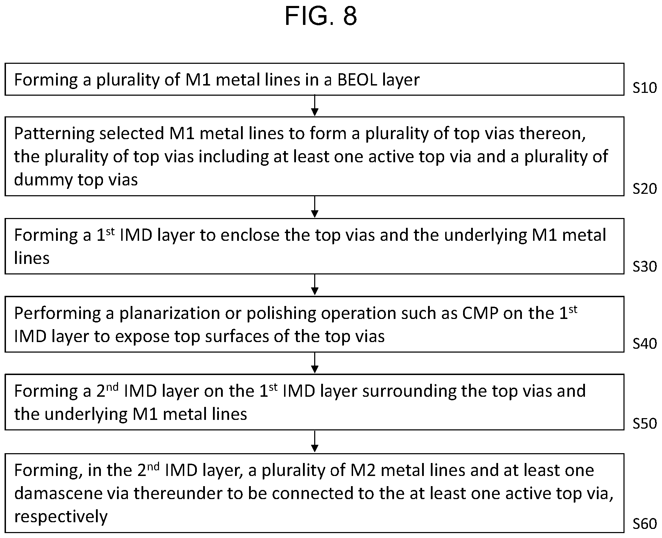

FIG. 8 illustrates a flowchart for a method of manufacturing a semiconductor device including a hybrid interconnect structure through both a top via process and a damascene process, according to one or more embodiments.

In step S10, a plurality of M1 metal lines may be formed in a BEOL layer. The M1 metal lines may be arranged in a D1 direction and extended in a D2 direction horizontally intersecting the D1 direction. The M1 metal lines may be formed of a metal such as Ru which may enable formation of the M1 metal lines having a very fine pitch. The M1 metal lines may be formed through, for example, photolithography, masking, etching and/or deposition operations such as dry etching, wet etching, physical vapor deposition (PVD), chemical vapor deposition (CVD), plasma enhanced chemical vapor deposition (PECVD), atomic layer deposition (ALD), etc., not being limited thereto.

Here, the M1 metal lines do not necessarily indicate that these metal lines are formed in the lowest layer of the BEOL layer, and there may be one or more other metal lines and vias below the M1 metal lines on an MOL or FEOL layer to form a semiconductor device.

In step S20, selected M1 metal lines may be patterned to form a plurality of top vias thereon. The top vias may be formed to have predetermined pitches in the D1 and D2 directions, respectively, to facilitate easy and fast detection of the top vias in a CMP operation in a later step. The top vias may include at least one active top via to be connected to an overlying M2 metal line and one or more dummy top vias which are not to be connected to any overlying M2 metal line. The formation of the top vias may be performed through, for example, photolithography, masking and etching such as dry etching or wet etching, not being limited thereto.

Each of the top vias is a part of a corresponding M1 metal line itself underlying the top via, and thus, there is no connection surface, boundary or interface between the top via and the underlying M1 metal line, unlike a metal line and a damascene via.

In step S30, a 1^{st} IMD layer may be formed to enclose the top vias and the underlying M1 metal lines to isolate these structural elements from each other or another circuit element. The formation of the 1^{st} IMD layer may be performed through, for example, depositing a low-k material such as silicon oxide (e.g., SiO₂) by PVD, CVD, PECVD, ALD, etc., not being limited thereto.

In step S40, a planarization or polishing operation such as CMP may be performed on the 1^{st} IMD layer to expose top surfaces of the top vias enclosed by the 1^{st} IMD layer. Due to the dummy top vias in addition to the active top via, a density of the top vias has increased. Further, the top vias are formed in a uniform pattern, that is, in the predetermined pitches. Thus, detection of the top vias may become easy and fast to avoid a possible via loss and a CMP dishing phenomenon.

In step S50, a 2^{nd} IMD layer may be formed on the 1^{st} IMD layer surrounding the top vias and the underlying M1 metal lines. The 2^{nd} IMD lay may be performed through, for example, depositing a low-k material which may be the same as or similar to the low-k material forming the 1^{st} IMD layer by PVD, CVD, PECVD, ALD, etc., not being limited thereto.

In step S60, a plurality of M2 metal lines and at least one damascene via thereunder may be formed in the 2^{nd} IMD layer to be connected to the at least one active top via, respectively. As the damascene via is formed on the active top via, enough space may be provided to avoid or reduce a possible risk of short-circuit or bridging between the damascene via and M1 metal lines not to be connected to M2 metal lines and between the active top via and M2 metal lines not to be connected to M1 metal lines.

The formation of the M2 metal lines and the damascene via may be performed though a single or dual damascene process.

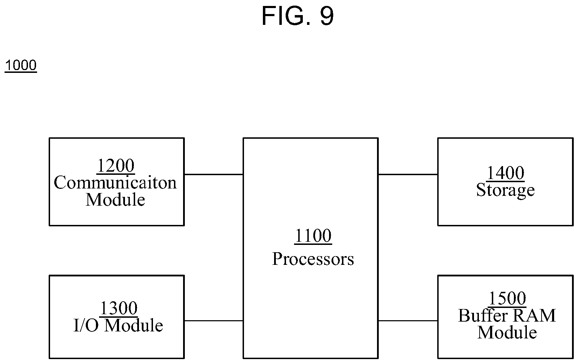

FIG. 9 is a schematic block diagram illustrating an electronic device including at least one of the interconnect structures 50 and 70 shown in FIGS. 5A-5C and 7A-7C, according to one or more embodiments.

Referring to FIG. 9, an electronic device 1000 may include at least one processor 1100, a communication module 1200, an input/output module 1300, a storage 1400, and a buffer random access memory (RAM) module 1500. The electronic device 1000 may be a mobile device such as a smartphone or a tablet computer, not being limited thereto, according to embodiments.

The processor 1100 may include a central processing unit (CPU), a graphic processing unit (GPU) and/or any other processors that control operations of the electronic device 1000. The communication module 1200 may be implemented to perform wireless or wire communications with an external device. The input/output module 1300 may include at least one of a touch sensor, a touch panel a key board, a mouse, a proximate sensor, a microphone, etc. to receive an input, and at least one of a display, a speaker, etc. to generate an output signal processed by the processor 1100. The storage 1400 may be implemented to store user data input through the input/output module 1300, the output signal, etc. The storage 1400 may be an embedded multimedia card (eMMC), a solid state drive (SSD), a universal flash storage (UFS) device, etc.

The buffer RAM module 1500 may temporarily store data used for processing operations of the electronic device 1000. For example, the buffer RAM 1500 may include a volatile memory such as double data rate (DDR) synchronous dynamic random access memory (SDRAM), low power double data rate (LPDDR) SDRAM, graphics double data rate (GDDR) SDRAM, Rambus dynamic random access memory (RDRAM), etc.

Although not shown in FIG. 15, the electronic device 1000 may further include at least one sensor such as an image sensor.

At least one component in the electronic device 1000 may include at least one of the interconnect structures 50 and 70 shown in FIGS. 5A-5C and 7A-7C, according to one or more embodiments.

The foregoing is illustrative of exemplary embodiments and is not to be construed as limiting the disclosure. Although a few exemplary embodiments have been described, those skilled in the art will readily appreciate that many modifications are possible in the above embodiments without materially departing from the scope of the appended claims.

## Claims

1. A semiconductor device comprising:
a transistor structure;
1^{st} metal lines (M11, M12, M13, M14, M15) above the transistor structure; and
1^{st} vias (dV, ATV) formed on respective 1^{st} metal lines among the 1^{st} metal lines (M11, M12, M13, M14, M15);
a 2^{nd} via (DV) formed on an active 1^{st} via (ATV) among the 1^{st} vias (dV, ATV); and
a 2^{nd} metal line (M22) on the 2^{nd} via (DV),
wherein the 1^{st} metal lines (M11, M12, M13, M14, M15) are arranged in a 1^{st} direction (D1) and extended in a 2^{nd} direction (D2) which intersects the 1^{st} direction (D1), and the 2^{nd} metal line (M22) is extended in the 1^{st} direction (D1), and
wherein the 1^{st} vias (dV, ATV) comprise at least one dummy via (dV) which is not connected to any metal line thereabove other than an underlying 1^{st} metal line among the respective 1^{st} metal lines.

2. The semiconductor device of claim 1, wherein each of the 1^{st} vias (dV, ATV) and each of the respective 1^{st} metal lines do not have a connection surface, boundary or interface therebetween.

3. The semiconductor device of claim 1 or 2, wherein the 2^{nd} metal line (M22) and the 2^{nd} via (DV) have a connection surface, boundary or interface (S2) therebetween, or
wherein the 2^{nd} metal line (M22) and the 2^{nd} via (DV) do not have a connection surface, boundary or interface therebetween.

4. The semiconductor device of any one of claims 1 to 3, wherein the 1^{st} metal lines (M11, M12, M13, M14, M15) and the 1^{st} vias (dV, ATV) are formed of at least one of ruthenium, Ru, molybdenum, Mo, and cobalt, Co, and/or
wherein the 2^{nd} metal line (M22) and the 2^{nd} via (DV) are formed of at least one of copper, Cu, aluminum, Al, and tungsten, W.

5. The semiconductor device of any one of claims 1 to 4, wherein a height of the at least one dummy via (dV) is the same as a height of the active 1^{st} via (ATV) in a 3^{rd} direction (D3) intersecting the 1^{st} and 2^{nd} directions (D1, D2).

6. The semiconductor device of any one of claims 1 to 5, wherein the at least one dummy via (dV) is not connected to any metal line thereabove.

7. The semiconductor device of any one of claims 1 to 6, wherein a 1^{st} metal line among the 1^{st} metal lines (M11, M12, M13, M14, M15) which is adjacent, in the 1^{st} direction (D1), to another 1^{st} metal line among the 1^{st} metal lines (M11, M12, M13, M14, M15), on which the active 1^{st} via (ATV) is formed, does not have a dummy via (dV) below the 2^{nd} metal line.

8. The semiconductor device of any one of claims 1 to 7, wherein a length of the 2^{nd} via (DV) is greater than a length of the active 1^{st} via (ATV) in the 1^{st} direction (D1), and a width of the 2^{nd} via (DV) is smaller than a width of the active 1^{st} via (ATV) in the 2^{nd} direction (D2).

9. The semiconductor device of any one of claims 1 to 8, further comprising:
a 1^{st} isolation layer (511, 711) surrounding the 1^{st} metal lines (M11, M12, M13, M14, M15) and the 1^{st} vias (dV, ATV); and
a 2^{nd} isolation layer (512, 712) surrounding the 2^{nd} via (DV),
wherein a diffusion barrier layer (B) is formed between the 2^{nd} via (DV) and the 2^{nd} isolation layer (512, 712), and
wherein a diffusion barrier layer is not formed between the 1^{st} vias (dV, ATV) and the 1^{st} isolation layer (511, 711).

10. The semiconductor device of any one of claims 1 to 9, further comprising a 3^{rd} isolation layer (513, 713) surrounding the 2^{nd} metal line (M22).

11. The semiconductor device of any one of claims 1 to 10, wherein the 1^{st} vias (dV, ATV) are arranged in the 1^{st} direction (D1) at a 1^{st} pitch.

12. The semiconductor device of any one of claims 1 to 11, wherein the at least one dummy via (dV) is of a line or bar type and extended in the 2^{nd} direction (D2).

13. The semiconductor device of any one of claims 1 to 12, wherein the 1^{st} vias (dV, ATV) are arranged in the 2^{nd} direction (D2) at a 2^{nd} pitch.

14. A method of manufacture a semiconductor device according to any one of the preceding claims, the method comprising forming a front-end-of-line, FEOL, structure and an interconnect structure connected to the FEOL structure,
wherein the forming the interconnect structure comprises:
forming (S10) 1^{st} metal lines (M11, M12, M13, M14, M15);
patterning (S20) respective 1^{st} metal lines among the one or more 1^{st} metal lines (M11, M12, M13, M14, M15) to form 1^{st} vias (dV, ATV) from the respective 1^{st} metal lines;
forming (S30) a 1^{st} isolation layer (511, 711) to enclose the 1^{st} metal lines (M11, M12, M13, M14, M15) and the 1^{st} vias (dV, ATV);
planarizing or polishing (S40) the 1^{st} isolation layer (511, 711) to expose the 1^{st} vias (dV, ATV); and
forming (S60) one or more 2^{nd} metal lines (M21, M22, M23) and a 2^{nd} via (DV) connected to one of the one or more 2^{nd} metal lines (M21, M22, M23) such that the 2^{nd} via (DV) is formed on an active 1^{st} via (ATV) among the 1^{st} vias (dV, ATV),
wherein 1^{st} vias (dV) other than the active 1^{st} via (ATV) among the 1^{st} vias (dV, ATV) are not connected to any of the 2^{nd} metal lines (M21, M22, M23).

15. The method of claim 14, wherein the forming (S60) the one or more 2^{nd} metal lines (M21, M22, M23) and the 2^{nd} via (DV) is performed through a damascene process.
